# EUROPEAN PATENT SPECIFICATION

(11) **EP 0 600 379 B1**
(45) Date of publication and mention of the grant of the patent: **28.07.1999**
(21) Application number: 93119019.3
(22) Date of filing: 25.11.1993
(51) Int. Cl.: H03L 7/191

(54) **Frequency synthesizer**
Frequenzsynthetisierer
Synthétiseur de fréquence

(30) Priority: 30.11.1992 ES 9202428
(43) Date of publication of application: 08.06.1994
(73) Proprietor: ALCATEL STANDARD ELECTRICA, S.A., 28045 Madrid (ES)
(72) Inventor: Fernandez Duran, Alfonso, E-28692 Villanueva de la Canada, Madrid (ES); Gonzales Ahijado, Angel, E-28916 Leganes, Madrid (ES); Perez Abadia, Mariano, E-28045 Madrid (ES)
(74) Representative: Feray, Valérie

(56) References cited:
- FR-A- 1 275 491
- US-A- 3 748 590
- US-A- 4 358 740
- PROCEEDINGS OF THE 15TH CONFERENCE OF ELECTRICAL & ELECTRONICS ENGINEERS IN ISRAEL 7 April 1987 pages 1 - 3 XP94398 ORI KOST ET AL. 'DOUBLE LOOP PLL BASED FREQUENCY SYNTHESIZER WITH A CONTINUOUS PHASE DIVIDER'
- F.D.natali, AFC Tracking algorithms IEEE Transactions on Communications, vol. COM-32,no.8, August 1984, pages 935-947

## Description

### Object of the invention

The present invention relates to a frequency synthesizer based on a phase lock loop structure (PLL), of the type composed by a reference signal generator that generates a reference signal, that is connected to a first phase detector that generates a first phase error signal, that in turn is connected to a first low pass filter that generates a first filtered phase error signal, and that is connected to a VCO and this one to a frequency divider that generates a first output signal, whose frequency is N times lower than the frequency of the signal at its input, and that in turn is connected to the first phase detector.

The frequency synthesizer of the invention is of special application in frequency synthesis when a high switching speed between channels is required.

### Background of the invention

There are many digital communication systems that make use of Multi-Frequency Time Division Multiple Access techniques (MF-TDMA). These systems use frequency synthesizers for generating the channel frequencies that will be used to transmit the digital information.

As the present systems work at high rates, it becomes necessary to reduce the guard time between consecutive time slots in order to keep a high efficiency of the system, which means that in case of change of the radio-frequency channel, the frequency synthesizer must switch its old frequency to the new one as quick as necessary to make sure that the new frequency is already established when the next time slot of the MF-TDMA system starts.

There are many techniques for minimizing the switching time between channels.

Some of them are based on the use of a loop filter whose bandwidth varies, being larger at the beginning when the loop is totally unlocked, and getting narrower when the loop is getting locked, as indicated in the article "Phase locked loop design for TDMA Applications" by C. Ryan, published into the 1985 IEEE Military Communications Conference MILCOM'85, Vol. 2, pp. 320 to 323.

The main drawback of this type of techniques is that when it is necessary to reduce the switching time between channels, it is also necessary to increase the complexity of the loop filter which results in that the synthesizer is more expensive and less reliable, increasing the possibility that the frequency synthesizer stability may be negatively affected.

### Technical problem to be overcome

So, the technical problem to be overcome is to reduve the switching time between channels, without increasing the complexity of the filter or filters of the frequency synthesizer and, in this way without affecting the stability of the frequency synthesizer.

### Characterization of the invention

The technical problem is solved by a frequency synthesizer as defined in claim 1.

In order to solve the above mentioned drawback, the frequency synthesizer of the invention is characterised in that the frequency divider disposes of a second output signal shifted 90° with respect to its other output signal.

Also, the frequency synthesizer of the invention includes a second phase detector that receives as inputs the reference signal and the second output signal from the frequency divider, and that generates a second phase error signal which is in quadrature with the first phase error signal generated by the first phase detector.

The frequency synthesizer of the invention is also characterized in that it includes a second low pass filter which is connected to the second phase detector and generates a second filtered phase error signal.

Finally, the frequency synthesizer is characterized in that it includes a quadratic correlator that receives, as inputs, the filtered phase error signals and that generates a third output signal to be supplied to the VCO and whose amplitude is proportional to the difference of frequencies between the reference signal and any of the output signals from the frequency divider.

The quadratic correlator can be either of the balanced type or of the unbalanced type.

With the application of this type of structure, important advantages are obtained, like a fast response to the channel switching, maintaining a high spectral purity of the synthesized signal, using a low complexity structure.

This allows it to be used in communication systems where a dinamic channel allocation is employed as, for instance, DECT (Digital European Cordless Telecommunication) system.

Another important advantages are the simplicity of the new elements that compose this structure that do not increase its cost appreciably and also that the working frequency range depends very little of the switching time and spectral purity of the ouput signal. Altogether it allows high performances in a frequency range wider than that of the conventional synthesizers.

### BRIEF FOOTNOTES TO THE FIGURES

A more detailed description of the invention will become apparent from the following description of a preferred implementation taken in conjunction with the accompanying drawings in which:
- figure 1 shows a general blok diagram of the synthesizer according to the invention;
- figure 2 shows a more detailed block diagram of block 8 in case that a balanced quadratic correlator is used; and
- figure 3 shows a more detailed block diagram of block 8 in case that an unbalanced quadratic correlator is used.

### DESCRIPTION OF THE INVENTION

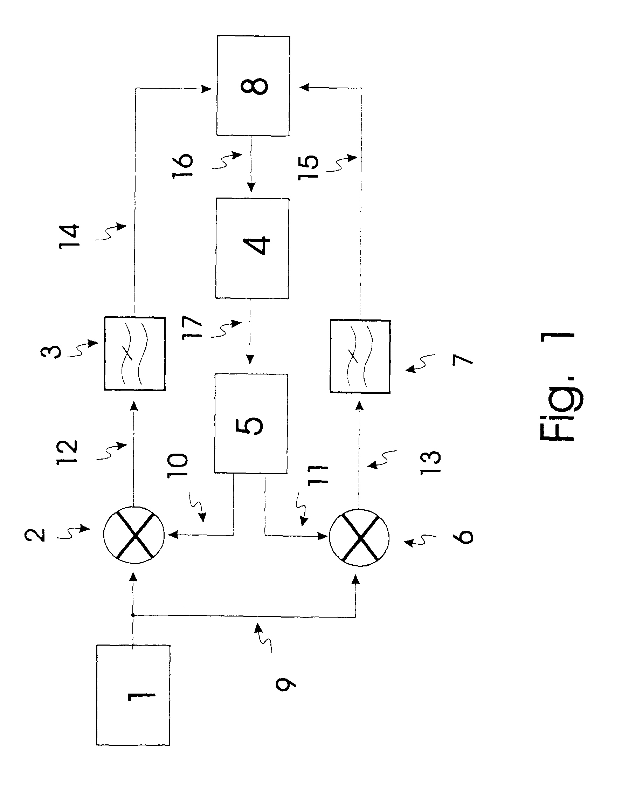

The block diagram of figure 1 represents a Phase Lock Loop as disclosed in the present invention. It is composed by a reference signal generator 1 that generates a reference signal 9, periodic, with the stability required by the system. This reference signal 9 supplies to a first phase detector 2 and to a second phase detector 6, to be compared with respective phases of output signals 10 and 11 coming from a frequency divider 5 and whose most representative characteristic is that both signals 10 and 11 are in quadrature, which means that their relative phase is shifted by 90°.

Phase error signals 12 and 13 coming respectively from phase detectors 2 and 6 supplies, also respectively, to the low pass filters 3 and 7, characterised by their high simplicity and whose task is to eliminate the frequency sum at the output of the phase comparators 2 and 6.

From the above mentioned low pass filters 3 and 7 it is attained first and a second filtered phase error signals 14 and 15, which are shifted 90 one each other that supply to a quadratic correlator 8; this last generating a control voltage 16 whose amplitude is proportional to the difference of frequencies between the reference signal 9 and any of the output signals 10, 11 from the frequency divider 5.

This control voltage 16 is applied to a VCO 4 (Voltage Controlled Oscillator), the frequency of its output signal 17 being the synthesized frequency, that depends proportionally of the voltage applied to its input.

The output signal 17 from the VCO 4 is applied to the frequency divider 5, this last attaining two output signals 10 and 11 whose frequency is the frequency of the output signal 17 from the VCO 4, divided by a N-factor and shifted in phase 90 one each other as previously indicated.

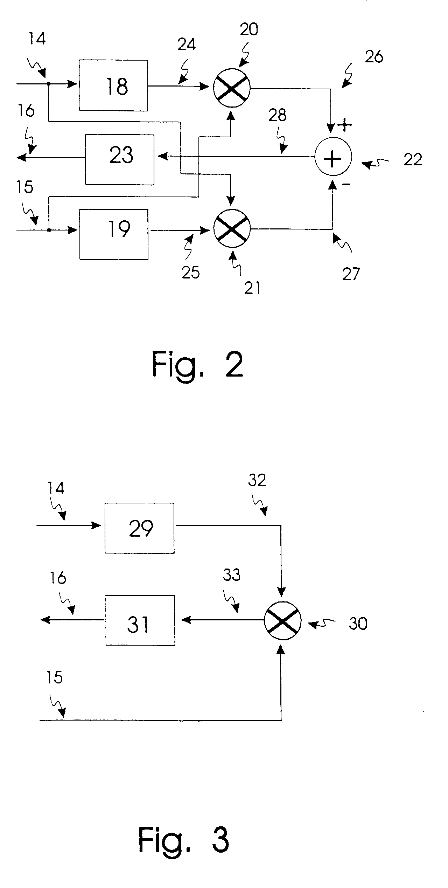

Figure 2 shows a possible implementation of the quadratic correlator 8, so-called balanced quadratic correlator.

It consists of two derivators 18 and 19 which are respectively supplied by the filtered phase error signals 14 and 15, generating respectively the derived signals 24 and 25. There is also a first multiplier 20 that multiplies the second filtered phase error signal 15 by the derived signal 24 of the filtered phase error signal 14, and a second multiplier 21 that multiplies the first filtered phase error signal 14 by the derived signal 25 of the second filtered phase error signal 15.

The respective output signals 26 and 27 from both multipliers 20 and 21 are subtracted, the second from the first, in a subtractor 22, that attains an output signal 28 whose amplitude has the form K (f₁-f₂), being K a proportionality constant and f₁ and f₂ respectively the frequencies of the reference signal 9 and of any of the output signals 10, 11 from the frequency divider 5.

This output signal 28 coming from the subtractor 22 is applied to a first integrator filter 23 that attains the control voltage 16 to be applied to the VCO 4.

Figure 3 shows another possible implementation of the quadratic correlator 8 so-called unbalanced quadratic correlator which is characterised by its great simplicity.

It is composed by a third derivator 29 that attains the derived signal 32 of the first filtered phase error signal 14.

This derived signal 32, coming from the third derivator 29, supplies to a third multiplier 30 that also receives the second filtered phase error signal 15 and that generates an output signal 33 whose amplitude has the form K (f₁ - f₂) [1 + cos 2(w₁ - w₂)t] that is proportional, as in the first case, to the frequency difference between the reference signal 9 and any of the output signals 10, 11 of the frequency divider 5, plus a ripple of frequency double of said frequency difference, and which is eliminated by the integrator filter 31 that receives the output signal 33 of the third multiplier 30 and that generates the voltage control 16 that will be applied the VCO 4.

## Claims

1. Frequency synthesizer for generating channel frequencies to transmit digital information, said frequency synthetizer being based on a phase lock loop structure composed by a reference signal generator (1) that generates a reference signal (9) that is connected to a first phase detector (2) that generates a first phase error signal (12), that in turn is connected to a first low pass filter (3) that generates a first filtered phase error signal (14) and that is connected to a VCO (4) and this to a frequency divider (5) that generates a first output signal (10) whose frequency is N times lower than the frequency of the signal (17) at its input, and that is connected to the first phase detector (2) and
**characterized**
- in that the frequency divider (5) has a second output signal (11) which is shifed 90° with respect to its first output signal (10);
- in that it includes a second phase detector (6) that receives, as inputs, the reference signal (9) and the second output signal (11) from the frequency divider (5), and that generates a second phase error signal (13) which is in quadrature with the first phase error signal (12) generated by the first phase detector (2);
- in that it includes a second low pass filter (7) which is connected to the second phase detector (6) and generates a second filtered phase error signal (15); and
- in that it includes a quadratic correlator (8) that receives, as inputs, both filtered phase error signals (14, 15) and that generates a third output signal (16) that is supplied to the VCO (4), and whose amplitude is proportional to the frequency difference between the reference signal and any of the output signals (10, 11) from the frequency divider (5).

2. Frequency synthesizer as claimed in claim 1, characterized in that the quadratic correlator (8) consists of:
- a first derivator (18) that receives the tirst filtered phase error signal (14) and that generates, at its output, a first derived signal (24);
- a second derivator (19) that receives the second filtered phase error signal (15) and that generates, at its output, a second derived signal (25);
- a first multiplier (20) that receives the first derived signal (24) and the second filtered phase error signal (15) and generates a fourth output signal (26);
- a second multiplier (21) that receives the second derived signal (25) and the first filtered phase error signal (14) and generates a fifth output signal (27);
- a first subtractor (22) that receives the fourth and fifth output signals (26, 27) and attains a sixth output signal (28) whose amplitude is proportional to the difference of frequencies between the reference signal (9) and any of the output signals (10, 11) from the frequency divider (5); and
- a first integrator filter (23) connected to the first subtractor (22) in order to filter the sixth output signal (28) from the first subtractor (22) and that attains a control voltage (16) to be applied to the VCO (4).

3. Frequency synthesizer as claimed in claim 1, characterized in that, in an alternative implementation the quadratic correlator (8) consists of:
- a third derivator (29) that receives the first filtered phase error signal (14) and that attains at its output, a third derived signal (32);
- a third multiplier (30) that receives the third derived signal (32) and the second filtered phase error signal (15), and generates a seventh output signal (33) whose amplitude is proportional to the frequency difference between the reference signal (9) and any of the output signals (10, 11) from the frequency divider (5) plus a ripple of frequency double of the frequency difference mentioned above; and
- a second integrator filter (31) connected to the third multiplier (30) in order to filter the seventh output signal (33) and that attains a control voltage (16) to be applied to the VCO (4).

## Patentansprüche

1. Frequenzsynthetisator zum Erzeugen von Kanalfrequenzen, zum Übertragen digitaler Information, wobei der Frequenzsynthetisator auf einer PLL-Anordnung basiert, die sich aus einem Referenzsignalgenerator (1) aufbaut, der ein Referenzsignal (9) erzeugt, und der mit einem ersten Phasendetektor (2) verbunden ist, der ein erstes Phasenfehlersignal (12) erzeugt, der wiederum mit einem ersten Tiefpaßfilter (3) verbunden ist, das ein erstes gefiltertes Phasenfehlersignal (14) erzeugt, welches mit einem VCO (4) verbunden ist, der mit einem Frequenzteiler (5) verbunden ist, der ein erstes Ausgangssignal (10) erzeugt, deren Frequenz N-mal niedriger ist als die Frequenz des Signals (17) an seinem Eingang, und der mit dem ersten Phasendetektor (2) verbunden ist, und dadurch gekennzeichnet,
- daß der Frequenzteiler (5) ein zweites Ausgangssignal (11) abgibt, welches um 90° verschoben ist, bezogen auf das erste Ausgangssignal (10);
- daß er einen zweiten Phasendetektor (6) umfaßt, der als Eingänge das Referenzsignal (9) und das zweite Ausgangssignal (11) von dem Frequenzteiler (5) empfängt, und der ein zweites Phasenfehlersignal (13) erzeugt, welches sich zu dem ersten Phasenfehlersignal (12) in Quadratur befindet, welches von dem ersten Phasendetektor (2) erzeugt wird;
- daß er ein zweites Tiefpaßfilter (7) umfaßt, das mit dem zweiten Phasendetektor (6) verbunden ist und das ein zweites gefiltertes Phasenfehlersignal (15) erzeugt; und
- daß er einen quadratischen Korrelator (8) umfaßt, der als Eingänge die beiden gefilterten Phasenfehlersignale (14, 15) erhält und der ein drittes Ausgangssignal (16) erzeugt, welches dem VCO (4) zugeführt wird, und dessen Amplitude proportional zu dem Frequenzunterschied zwischen dem Referenzsignal und einem der Ausgangssignale (10, 11) von dem Frequenzteiler (5) ist.

2. Frequenzsynthetisator nach Anspruch 1, dadurch gekennzeichnet, daß der quadratische Korrelator (8) umfaßt:
- ein erstes Ableitglied (18), das das erste gefilterte Phasenfehlersignal (14) empfängt und daß als Ausgangsgröße ein erstes abgeleitetes Signal (24) erzeugt;
- ein zweites Ableitglied (19), das das zweite gefilterte Phasenfehlersignal (15) empfängt und daß als Ausgangsgröße ein zweites abgeleitetes Signal (25) erzeugt;
- einen ersten Multiplizierer (20), der das erste abgeleitete Signal (24) und das zweite gefilterte Phasenfehlersignal (15) empfängt und der ein viertes Ausgangssignal (26) erzeugt;
- einen zweiten Multiplizierer (21), der das zweite abgeleitete Signal (25) und das erste gefilterte Phasenfehlersignal (14) empfängt und der ein fünftes Ausgangssignal (27) erzeugt;
- einen ersten Subtraktor (22), der das vierte und das fünfte Ausgangssignal (26, 27) empfängt und der ein sechstes Ausgangssignal (28) abgibt, dessen Amplitude proportional zu der Differenz zwischen dem Referenzsignal (9) und einem der Ausgangssignale (10, 11) von dem Frequenzteiler (5) ist; und
- ein erstes Integratorfilter (23), welches mit dem ersten Subtraktor (22) verbunden ist, um das sechste Ausgangssignal (28) von dem ersten Subtraktor (22) zu filtern und welches eine Steuerspannung (16) abgibt, die an den VCO (4) angelegt wird.

3. Frequenzsynthetisator nach Anspruch 1, dadurch gekennzeichnet, daß bei einer anderen Ausführungsform der quadratische Korrelator (8) umfaßt:
- ein drittes Ableitglied (29), welches das erste gefilterte Phasenfehlersignal (14) erhält und welches als Ausgangsgröße eine drittes abgeleitetes Signal (32) abgibt;
- einen dritten Multiplizierer (30), der das dritte abgeleitete Signal (32) und das zweite gefilterte Phasenfehlersignal (15) empfängt und der ein siebtes Ausgangssignal (33) erzeugt, dessen Amplitude proportional zu dem Frequenzunterschied zwischen dem Referenzsignal (9) und einem der Ausgangssignale (10, 11) von dem Frequenzteiler (5) ist, plus eine Restwelligkeit des Frequenzdoppels des obigen Frequenzunterschieds; und
- ein zweites Integratorfilter (31), welches mit dem dritten Multiplizierer (30) verbunden ist, um das siebte Ausgangssignal (33) zu filtern und welches eine Steuerspannung (16) abgibt, die an den VCO (4) angelegt wird.

## Revendications

1. Synthétiseur de fréquences pour générer des fréquences de canal pour transmettre des informations numériques, ledit synthétiseur de fréquences se basant sur une structure de boucle à phase asservie se composant d'un générateur de signal de fréquence (1) qui génère un signal de référence (9) qui est connecté à un premier détecteur de phase (2) qui génère un premier signal d'erreur de phase (12), qui à son tour est connecté à un premier filtre passe-bas (3) qui génère un premier signal d'erreur de phase filtré (14) et qui est connecté à un oscillateur commandé en tension (4) et celui-ci est connecté à diviseur de fréquence (5) qui génère un premier signal de sortie (10) dont la fréquence est N fois inférieure à la fréquence du signal (17) à son entrée, et qui est connecté au premier détecteur de phase (2) et
caractérisé
- en ce que le diviseur de fréquence (5) possède un deuxième signal de sortie (11) qui est décalé de 90° par rapport à son premier signal de sortie (10) ;
- en ce qu'il comprend un second détecteur de phase (6) qui reçoit, comme entrées, le signal de référence (9) et le deuxième signal de sortie (11) délivrés par le diviseur de fréquence (5), et qui génère un deuxième signal d'erreur de phase (13) qui est en quadrature avec le premier signal d'erreur de phase (12) généré par le premier détecteur de phase (2) ;
- en ce qu'il comprend un second filtre passe-bas (7) qui est connecté au second détecteur de phase (6) et génère un deuxième signal d'erreur de phase filtré (15) ; et
- en ce qu'il inclut un corrélateur quadratique (8) qui reçoit, comme entrées, les deux signaux d'erreur de phase filtrés (14, 15) et qui génère un troisième signal de sortie (16) qui est délivré à l'oscillateur commandé en tension (4), et dont l'amplitude est proportionnelle à la différence de fréquences entre le signal de référence et un signal quelconque parmi les signaux de sortie (10, 11) provenant du diviseur de fréquence (5).

2. Synthétiseur de fréquences selon la revendication 1, caractérisé en ce que le corrélateur quadratique (8) se compose de :
- un premier dérivateur (18) qui reçoit le premier signal d'erreur de phase filtré (14) et qui génère, à sa sortie, un premier signal dérivé (24) ;
- un deuxième dérivateur (19) qui reçoit le deuxième signal d'erreur de phase filtré (15) et qui génère, à sa sortie, un second signal dérivé (25) ;
- un premier multiplieur (20) qui reçoit le premier signal dérivé (24) et le deuxième signal d'erreur de phase filtré (15) et génère un quatrième signal de sortie (26) ;
- un second multiplieur (21) qui reçoit le second signal dérivé (25) et le premier signal d'erreur de phase filtré (14) et génère un cinquième signal de sortie (27) ;
- un premier soustracteur (22) qui reçoit les quatrième et cinquième signaux de sortie (26, 27) et atteint un sixième signal de sortie (28) dont l'amplitude est proportionnelle à la différence de fréquences entre le signal de référence (9) et un signal quelconque parmi les signaux de sortie (10, 11) provenant du diviseur de fréquence (5) ; et
- un premier filtre d'intégrateur (23) connecté au premier soustracteur (22) afin de filtrer le deuxième signal de sortie (28) provenant du premier soustracteur (22) et qui atteint une tension de commande (16) devant être appliquée à l'oscillateur commandé en tension (4).

3. Synthétiseur de fréquences selon la revendication 1, caractérisé en ce que, dans une variante de mise en oeuvre, le corrélateur quadratique (8) se compose de :
- un troisième dérivateur (29) qui reçoit le premier signal d'erreur de phase filtré (14) et qui atteint à sa sortie, un troisième signal dérivé (32) ;
- un troisième multiplieur (30) qui reçoit le troisième signal dérivé (32) et le deuxième signal d'erreur de phase filtré (15), et génère un septième signal de sortie (33) dont l'amplitude est proportionnelle à la différence de fréquences entre le signal de référence (9) et un signal quelconque parmi les signaux de sortie (10, 11) provenant du diviseur de fréquence (5) plus une ondulation de fréquence double de la différence de fréquences mentionnée ci-dessus ; et
- un second filtre d'intégrateur (31) connecté au troisième multiplieur (30) afin de filtrer le septième signal de sortie (33) et qui atteint une tension de commande (16) devant être appliquée à l'oscillateur commandé en tension (4).
